# EUROPEAN PATENT APPLICATION

(11) **EP 2 341 597 A1**
(43) Date of publication of application: **06.07.2011**
(21) Application number: 09821746.6
(22) Date of filing: 02.10.2009
(51) Int. Cl.: H02J 7/00, B60L 3/00, B60L 11/18, H01M 10/42, H01M 10/44, H01M 10/48, H02H 7/18

(54) **FAILURE DIAGNOSIS CIRCUIT, POWER SUPPLY DEVICE, AND FAILURE DIAGNOSIS METHOD**

(30) Priority: 24.10.2008 JP 2008274551
(71) Applicant: Panasonic Corporation, Kadoma-shi Osaka 571-8501 (JP)
(72) Inventor: IIDA, Takuma, Osaka-shi, Osaka 540-6207 (JP)
(74) Representative: Schwabe - Sandmair - Marx
(86) International application number: PCT/JP2009/005098
(87) International publication number: WO 2010/047046

(57) **Abstract**

A failure diagnosis circuit is provided with: a voltage detection unit that detects a terminal voltage of an electricity storage unit; a current detection unit that detects a current flowing in the electricity storage unit; a SOC calculation unit that calculates a SOC of the electricity storage unit on the basis of the current detected by the current detection unit; a charging stopping unit that stops charging of the electricity storage unit when the SOC calculated by the SOC calculation unit reaches a preset determination value; and a failure detection unit that determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.

## Description

### Technical Field

The present invention relates to a failure diagnosis method for detecting a failure of a voltage detection unit that detects a terminal voltage of an electricity storage unit, a failure diagnosis circuit, and a power supply device using the same.

### Background Art

Electricity storage devices using electricity storage units have been widely used in recent years as power supply systems in combinations with solar cells or power generating devices. Power generating devices are driven by natural energy such as wind power of water power or artificial power such as that of an internal combustion engine. In a power supply system incorporating such an electricity storage device, excess power is accumulated and stored in the electricity storage device and this power is supplied from the electricity storage device when it is required by a load device, thereby increasing the energy efficiency.

A solar power generating system is an example of such system. When the quantity of electricity created by solar light is greater than the power consumed by the load device in a solar power generating system, the excess power is charged into the electricity storage device. Conversely, when the quantity of generated electricity is less than the power consumed by the load device, the power is outputted from the electricity storage device to compensate lack of power, and the output device is driven by the outputted power.

Thus, in the solar power generating system, the excess power, which has heretofore not been used, is accumulated in the electricity storage device and energy efficiency can be increased over that of a power supply system that does not use an electricity storage device.

In such a solar power generating system, where the electricity storage device is fully charged, the excess power cannot be charged into the electricity storage device and is lost. Accordingly, charge control is performed such that the state of charge (abbreviated hereinbelow as SOC) of the electricity storage device does not become 100% in order to charge the extra power into the electricity storage device with good efficiency. Further, charge control is performed such that the SOC does not become 0% (zero) so that the load device could be driven when necessary. More specifically, charge control of the electricity storage device is usually performed to shift the SOC into a range of 20% to 80%.

Further, a hybrid automobile using an engine and a motor (HEV; Hybrid Electric Vehicle) also uses this principle. In the HEV, when the output from the engine is larger than the power necessary for traveling, an electricity storage device is charged. Further, when the HEV is braked or decelerated, the electricity storage device is charged by using the motor as a generator.

Load leveling power supply devices that are used for effective usage of nighttime power and plug-in hybrid vehicles have recently attracted attention. The load leveling power supply devices are systems that store power in an electricity storage device during the night when power consumption is low and power cost is also low and use the stored power during daytime when power consumption peaks. The object of such systems is to obtain a constant amount of generated power and make contribution to efficient use of power facilities and reduce investment in the facilities by equalizing power consumption.

Another object is to reduce the total emission of CO₂, which is possible when the plug-in hybrid vehicles use nighttime power, mainly perform EV traveling in which power is supplied from the electricity storage device when traveling on city roads where power consumption is high, and perform HEV traveling using the engine and motor in long-distance traveling.

In such electricity storage device, the terminal voltage of the electricity storage unit is monitored, overcharging or overdischarging of the electricity storage unit is prevented and application of overvoltage to the electricity storage unit is also prevented, thereby reducing the deterioration of the electricity storage unit and preventing the decrease in safety.

Therefore, where a failure occurs in a circuit of voltage measurement system that detects the terminal voltage of the electricity storage unit, the terminal voltage of the electricity storage unit cannot be monitored correctly, the electricity storage unit can be overdischarged or overcharged, and safety can decrease.

A technique is known by which failure diagnosis of a voltage detection circuit for detecting abnormalities is performed by attempting to charge a battery to an abnormal determination level exceeding the usual range of use and determining whether or not an abnormality can be detected from terminal voltage of the battery (for example, see Patent Document 1).

However, with the method disclosed in Patent Document 1, the battery should be charged to a level above the usual range of use in order to perform failure diagnosis of the voltage detection circuit. The resultant drawback is that the failure diagnosis accelerates the deterioration of battery.

Patent Document 1: Japanese Patent Application Publication No. 2004-312835

### Summary of Invention

It is an object of the present invention to provide a failure diagnosis circuit that can detect a failure of a voltage detection unit that outputs a terminal voltage of an electricity storage unit, without enhancing the deterioration of the electricity storage unit, and also to provide a power supply device and a failure diagnosis method.

The failure diagnosis circuit according to one aspect of the present invention includes: a voltage detection unit that detects a terminal voltage of an electricity storage unit; a current detection unit that detects a current flowing in the electricity storage unit; a SOC calculation unit that calculates a SOC of the electricity storage unit on the basis of the current detected by the current detection unit; a charging stopping unit that stops charging of the electricity storage unit when the SOC calculated by the SOC calculation unit reaches a preset determination value; and a failure detection unit that determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.

The failure diagnosis method according to another aspect of the present invention includes: a step in which a voltage detection unit detects a terminal voltage of an electricity storage unit; a step in which a current detection unit detects a current flowing in the electricity storage unit; a step in which a SOC calculation unit calculates a SOC of the electricity storage unit on the basis of the current detected by the current detection unit; a step in which a charging stopping unit stops charging of the electricity storage unit when the SOC calculated by the SOC calculation unit reaches a preset determination value; and a step in which a failure detection unit determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.

The variation of the terminal voltage after the charging of the electricity storage unit is stopped is determined according to the SOC. Accordingly, with such a configuration, charging of the electricity storage unit is stopped when the SOC calculated on the basis of current flowing in the electricity storage unit becomes the determination value. Where the variation of the terminal voltage, which is detected by the voltage detection unit, after the charging is stopped by the charging stopping unit differs from the predicted variation when the SOC of the electricity storage unit is at the determination value, it is highly probable that the terminal voltage detected by the voltage detection unit is erroneous. Therefore, when the variation of the terminal voltage, which is detected by the voltage detection unit, after the charging is stopped by the charging stopping unit differs from the predicted variation when the SOC of the electricity storage unit is at the determination value, a failure can be determined to have occurred in the voltage detection unit. In this case, it is not necessary to charge the electricity storage unit to a level above the usual range of use in order to perform failure diagnosis of the voltage detection circuit which detects the terminal voltage of the electricity storage unit. Therefore the failure of the voltage detection unit can be detected without accelerating the deterioration of the electricity storage unit.

The power supply device according to another aspect of the present invention includes the abovementioned failure diagnosis circuit and the electricity storage unit.

With such a configuration, it is not necessary to charge the electricity storage unit to a level above the usual range of use in order to perform failure diagnosis of the voltage detection circuit, which detects the terminal voltage of the electricity storage unit, in a power supply device including the electricity storage unit. Therefore the failure of the voltage detection unit can be detected without accelerating the deterioration of the electricity storage unit.

With the abovementioned failure diagnosis circuit, power supply device, and failure diagnosis method, it is not necessary to charge the electricity storage unit to a level above the usual range of use in order to perform failure diagnosis of the voltage detection unit, which detects the terminal voltage of the electricity storage unit. Therefore the failure of the voltage detection unit can be detected without accelerating the deterioration of the electricity storage unit.

### Brief Description of the Drawings

Fig. 1 is a block diagram illustrating an example of a configuration of a failure diagnosis circuit using the failure diagnosis method according to one embodiment of the present invention, a power supply device including the failure diagnosis circuit, and a power supply system.
Fig. 2 is an explanatory drawing for explaining the variation of a terminal voltage when a charge current is made zero after the charge current has flown into the electricity storage element.
Fig. 3 is a flowchart illustrating an operation example of the power supply device shown in Fig. 1.

### Description of Embodiments

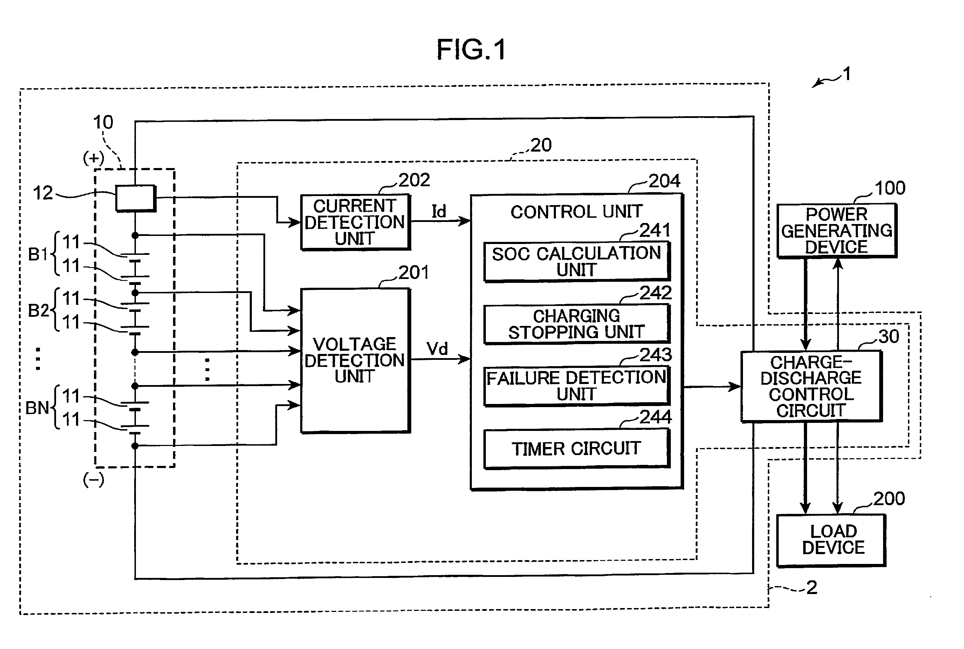

The embodiments of the present invention will be described below with reference to the appended drawings. In the drawings, the components denoted by like reference numerals represent like components and the explanation thereof is herein omitted. Fig. 1 is a block diagram illustrating an example of a configuration of a failure diagnosis circuit using the failure diagnosis method according to one embodiment of the present invention, a power supply device including the failure diagnosis circuit, and a power supply system.

The power supply system 1 shown in Fig. 1 is constituted by a power supply device 2, a power generating device 100, and a load device 200. A variety of power supply devices, for example a battery pack, an uninterruptable power supply device, an electricity storage device for power adjustment that stores extra power of a power generating device using an engine as a drive source and a power generating device using natural energy, and a load leveling power source can be used as the power supply device 2.

The load device 200 receives power supply from the power generating device 100 or the power supply device 2.

The power generating device 100 is specifically a power generating device using natural energy such as a solar power generating device (solar cell) or a power generator using an engine as a drive source. The power supply device 2 may be configured to receive power supply from a commercial power source instead of the power generating device 100.

The power supply device 2 includes an electricity storage device 10, a failure diagnosis circuit 20, and a charge-discharge control circuit 30. The failure diagnosis circuit 20 is provided with a voltage detection unit 201, a current detection unit 202, and a control unit 204.

The electricity storage device 10 is constituted, for example, as a battery pack in which a total of N electricity storage units B1, B2, ..., BN connected in series and a current sensor 12 are connected in series and accommodated in a housing (box) (not shown in the figure). Each of the electricity storage units B1, B2, ..., BN is a battery block configured by connecting a plurality of electricity storage elements 11 in series. The electricity storage units B1, B2, ... BN will be denoted hereinbelow simply as the electricity storage unit B.

The current sensor 12 is constituted for example by a resistance element or current converter connected in series to the electricity storage unit B, detects the electric current flowing in the electricity storage unit B, and outputs the detected current value as a voltage signal to the current detection unit 202.

An electricity storage element, for example, an alkali storage battery such as a nickel hydride battery, an organic battery such as a lithium ion battery, and a capacitor such as an electric double-layer capacitor can be used as the electricity storage element 11.

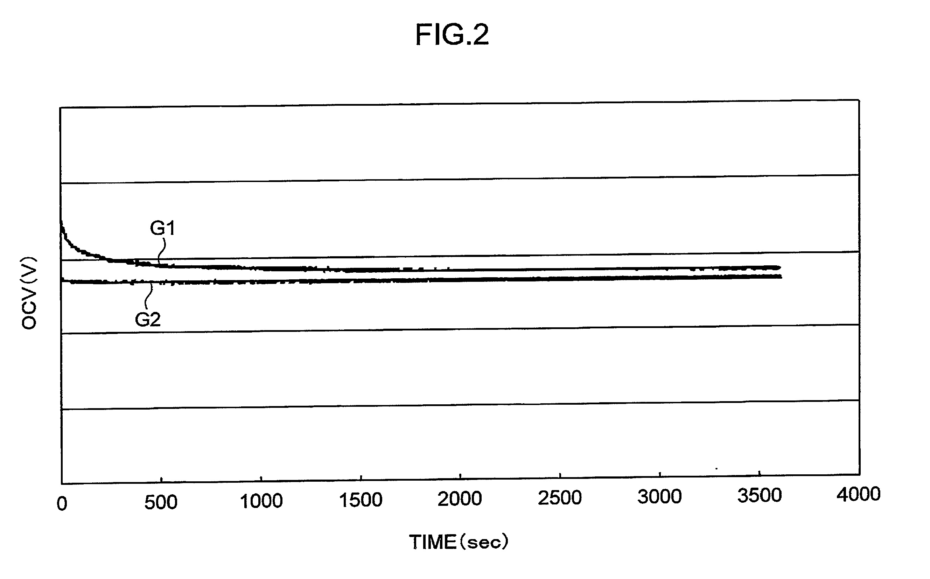

Fig. 2 is an explanatory drawing serving to explain the variation of a terminal voltage (OCV) when the charge current is made zero (charging is stopped) after the charge current has flown in a lithium ion secondary battery using LiFePO₄, which is an example of an olivine-type lithium transition metal phosphate, as a positive electrode active material. Graph G1 represents the case in which the charging is stopped at a SOC of 100% and graph G2 represents the case in which the charging is stopped at a SOC of 70%. In Fig. 2, the terminal voltage (OCV) of the secondary battery is plotted against the ordinate, and the time elapsed after the charging is stopped is plotted against the abscissa.

As shown in graphs G1, G2 in Fig. 2, the electricity storage element 11 is used such that the decrease amount of the terminal voltage (OCV) till a stationary value is assumed after the charging is stopped (decrease amount within a predetermined time duration) increases with the increase in the electricity storage amount (SOC), that is, as a fully charged state is approached.

More specifically, a lithium ion secondary battery using LiFePO₄, which is an example of an olivine-type lithium transition metal phosphate, as a positive electrode active material can be advantageously used as the electricity storage element 11. The positive electrode active material may be, for example, LiₓA_{y}B_{z}PO₄ (where A is at least one species selected from Me, Fe, Mn, Co, Ni, and Cu; B is at least one species selected from Mg, Ca, Sr, Sc, Y, Ti, Zr, V, Nb, Cr, Mo, W, Ag, Zn, In, Sn, and Sb; and 0 < X ≤ 1, 0.9 ≤ Y ≤ 1, 0 ≤ Z ≤ 0.1), more preferably LiₓFePO₄ (0 < x ≤ 1).

The inventors have experimentally discovered that a lithium ion secondary battery using LiFePO₄ as a positive electrode active material has a property such that the decrease amount per predetermined time of the terminal voltage after the charging is stopped increases with the increase in SOC, as shown in Fig. 2.

Thus, the difference between the terminal voltage immediately before the charging is stopped and the terminal voltage after a predetermined time elapses since the charging is stopped was experimentally found to be higher when the electricity storage element 11 is fully charged (graph G1) than when the SOC of the electricity storage element 11 is small (graph G2). In other words, as shown in Fig. 2, the slope of the decrease curve of the terminal voltage after the charging is stopped, that is, the decrease amount, per a predetermined time, of the terminal voltage after the charging is stopped is higher when the electricity storage element 11 is fully charged (graph G1) than when the SOC of the electricity storage element 11 is small (graph G2).

A lithium ion secondary battery using an olivine-type lithium transition metal phosphate is but an example of the electricity storage element 11, and various other secondary batteries can be used as the electricity storage element 11. The number of electricity storage units, number of electricity storage elements 11, and connection state thereof are not particularly limited. For example, each electricity storage unit may be constituted by connecting a plurality of electricity storage elements 11 in series, in parallel, or in a manner combining series and parallel connection. Further, each electricity storage unit may be a respective individual electricity storage element 11. The configuration of the electricity storage device 10 is also not limited to that described hereinabove.

The charge-discharge control circuit 30 charges, for example, the extra power generated by the power generating device 100 or regenerated power generated in the load device 200 into the electricity storage device 10. Further, where the current consumed by the load device 200 rapidly increases or the amount of power generated by the power generating device 100 decreases and the power required for the load device 200 exceeds the output of the power generating device 100, the lacking power is supplied by the charge-discharge control circuit 30 from the electricity storage device 10 to the load device 200.

The charge-discharge control circuit 30 also stops or allows the charging of the electricity storage device 10 in response to a control signal from the control unit 204. In this case, the charge-discharge control circuit 30 or power generating device 100 corresponds to an example of a charging unit.

Where charging and discharging of the electricity storage device 10 is thus controlled by the charge-discharge control circuit 30, the SOC of the electricity storage device 10 is within a range of about 20 to 80% in the usual case. Alternatively, in a plug-in hybrid vehicle or a load leveling power source that effectively uses nighttime power, the electricity storage device 10 is charged to a 100% SOC state and the discharge is performed when the energy is required by the load device 200.

The voltage detection unit 201 is a voltage detection circuit that detects the terminal voltage V1, V2, ..., VN of electricity storage units B1, B2, ..., BN and outputs the detected values to the control unit 204. The voltage detection unit 201 can be configured by using, for example, an analog-digital converter and a switching circuit that selects any one from among the terminal voltages V1, V2, ..., VN of electricity storage units B1, B2, ..., BN in response to a control signal from the control unit 204 and outputs the selected voltage to the analog-digital converter.

The current sensor 12 is constituted, for example, by a shunt resistor or current converter connected in series to the electricity storage unit, detects the current flowing in the electricity storage unit B, and outputs the current value as the voltage signal to the current detection unit 202. The current detection unit 202 is constituted by using, for example, an analog-digital converter, converts the voltage indicating the current value obtained by the current sensor 12 into a digital value, and outputs the digital value as a charge-discharge current value Id to the control unit 204. In the charge-discharge current value Id, the current in the charge direction of the electricity storage unit B is indicated by a positive (plus) value, and the current in the discharge direction of the electricity storage unit B is indicated by a negative (minus) value.

The control unit 204 is provided, for example, with a CPU (Central Processing Unit) executing the predetermined computational processing, a ROM (Read Only Memory) storing a predetermined control program, a RAM (Random Access Memory) that temporarily stored data, a timer circuit 244, and peripheral circuits thereof.

For example, by executing the control program stored in the ROM, the control unit 204 functions as a SOC calculation unit 241, a charging stopping unit 242, and a failure detection unit 243. The charge-discharge control circuit 30 or load device 200 may be constituted by the entire control unit 204 or part thereof.

The SOC calculation unit 241 calculates an integral charge quantity Q by integrating, for example with respect to each unit time, the charge-discharge current value Id outputted from the current detection unit 202. Since the charge-discharge current value Id is positive in the charging direction and negative in the charging direction, when the integration is performed, the integral charge quantity Q charged into the electricity storage unit B is calculated by adding the electric charges during charging and subtracting the electric charges during discharging.

Further, during charging, that is, when the charge-discharge current value Id is positive, the SOC calculation unit 241 performs integration after multiplying the charge-discharge current value Id by charging efficiency (coefficient less than 1, for example, 0.8) to increase the calculation accuracy of the integral charge quantity Q. Further, the SOC calculation unit 241 calculates the SOC of the electricity storage device 10, for example, by calculating the ratio of the integral charge quantity Q to the full-charge capacity of the electricity storage device 10.

Further, the SOC calculation unit 241 may also calculate the SOC of electricity storage units B1, B2, ..., BN as SOC1, SOC2, ..., SOCN for each battery block, calculate the SOC for each electricity storage element 11, or calculate the SOC for the entire electricity storage device 10.

When the temperature of the electricity storage device 10 is detected and the temperature of the electricity storage device 10 changes significantly, it is preferred that the SOC calculation unit 241 correct the calculated value of the integral charge quantity Q with consideration for a variation of charging efficiency caused, for example, by temperature.

When the SOC calculated by the SOC calculation unit 241 becomes equal to or higher than a determination value α that has been set in advance, the charging stopping unit 242 outputs a control signal to the charge-discharge control circuit 30 and stops the supply of current from the charge-discharge control circuit 30 to the electricity storage device 10, thereby stopping the charging of the electricity storage unit B.

For example, an upper limit value of the range of SOC that has been set in advance as a target for using the electricity storage unit B is set as the determination value α. For example, in the case in which the power supply device 2 is used in a SOC range of 20 to 80%, such as the case of a power supply device for power adjustment, a value of 80% can be advantageously used as the determination value α. Further, for example, in the case in which the power supply device 2 is used at a 100% SOC, that is, when the electricity storage unit B is fully charged, e.g. as in the case of a power supply device for use in a plug-in hybrid vehicle or load leveling power source, a value of 100% can be advantageously used as the determination value α.

Where an upper limit value of the range of SOC that has been set in advance as a target for using the electricity storage unit B is set as the determination value α, the charging can be stopped when it is necessary to stop the charging to control the SOC in a target range and failure diagnosis can be executed, irrespectively of the failure diagnosis operation performed by the failure diagnosis circuit 20. Therefore, since the necessity of stopping the charging for only failure diagnosis is eliminated, the convenience of the power supply device 2 in use can be increased.

In particular, in the case in which an electricity storage element, such that the decrease amount per a predetermined time of the terminal voltage after the charging is stopped increases with the increase in SOC, is used as the electricity storage element 11, when the electricity storage unit B is close as possible to a fully charged state within the usually used range of SOC, that is, when the decrease amount per a predetermined time of the terminal voltage after the charging is stopped becomes as large as possible, failure detection of the voltage detection unit 201 is performed by the failure detection unit 243 on the basis of variations in the terminal voltage. Therefore, the failure can be determined on the basis of a relatively large variation. As a result, the detection accuracy of the failure detection can be increased.

The failure detection unit 243 detects a failure of the voltage detection unit 201 on the basis of variation of the terminal voltage detected by the voltage detection unit 201 after the charging is stopped by the charging stopping unit 242. Thus, in the electricity storage element 11, the variation of terminal voltage after the charging is stopped differs according to SOC, for example, as shown by graphs G1 and G2 in Fig. 2.

When the SOC calculated by the SOC calculation unit 241 on the basis of the charge-discharge current value Id detected by the current sensor 12 or current detection unit 202 becomes the determination value α, where the variation of the terminal voltage detected by the voltage detection unit 201 after the charging is stopped is not realized changes, or the variation is realized that differs from the predicted variation when SOC is at the determination value α, the probability of a failure occurring in the voltage detection unit 201 is high. Therefore, a failure of the voltage detection unit 201 can be detected.

In this case, a spread of variation of the terminal voltage, which is detected by the voltage detection unit 201 after the charging is stopped, this spread being caused by the effect, for example, of a spread of properties among the electricity storage units, is less than that of the terminal voltage of the electricity storage unit B when the SOC is at the predetermined value, for example, the determination value α, and therefore the accuracy of failure diagnosis is increased over that attained when failure diagnosis is conducted by simply comparing the terminal voltage of the electricity storage unit B obtained with the voltage detection unit 201 when the SOC is at the determination value α with a preset reference value.

The timer circuit 244 is used to cause the voltage detection unit 201 to detect the terminal voltage V1, V2, ..., VN periodically, for example, per unit time and calculate the voltage variation amount per unit time or count the time elapsed since the charging is stopped.

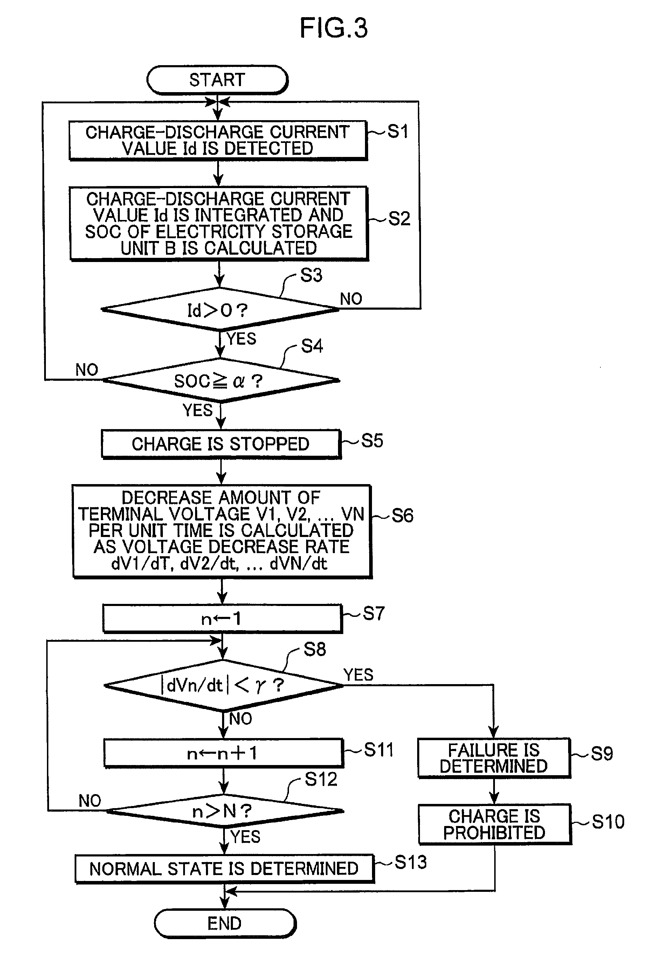

The operation of the power supply device 2 shown in Fig. 1 will be explained below. Fig. 3 is a flowchart illustrating an example of operation of the power supply device 2 shown in Fig. 1. First, the charge-discharge current value Id of the current flowing in the electricity storage unit B is detected by the current detection unit 202 (step S1), the charge-discharge current value Id is integrated by the SOC calculation unit 241, and the SOC of the electricity storage unit B is calculated (step S2).

Then, the charge-discharge current value Id is compared with zero by the charging stopping unit 242 (step S3). When the charge-discharge current value Id is equal to or less than zero, that is, when the electricity storage unit B is not charged (NO in step S3), the steps S1 to S3 are repeated, but when the charge-discharge current value Id is above zero, thereby indicating the charging of the electricity storage unit B, that is, when the electricity storage unit B is being charged (YES in step S3), a transition is made to step S4.

An example is considered in which whether or not the electricity storage unit B is being charged is determined on the basis of the charge-discharge current value Id in step S3, but a configuration may be also used in which, for example, a signal indicating as to whether or not the electricity storage unit B is being charged is acquired from the charge-discharge control circuit 30 and a transition is made to step S4 when this signal indicates that the electricity storage unit B is being charged.

In step S4, the charging stopping unit 242 compares the SOC calculated by the SOC calculation unit 241 with the determination value α (step S4). If the SOC is less than the determination value α (NO in step S4), the steps S1 to S3 are repeated, but if the SOC is equal to or higher than the determination value α (YES in step S4), a transition is made to step S5.

In step S5, the charging stopping unit 242 outputs a signal indicating the charging stop to the charge-discharge control circuit 30, and the charge-discharge control circuit 30 stops the supply of current to the electricity storage device 10 and stops the charging of the electricity storage unit B (step S5).

Then, the failure detection unit 243 calculates the variation amount, within predetermined time duration, for example, per unit time, of the terminal voltage V1, V2, ...VN detected by the voltage detection unit 201, immediately after the charging is stopped by the charging stopping unit 242 (step S6). The variation amount is calculated as the voltage decrease rate dV1/dt, dV2/dt, ..., dVN/dt.

As shown in graph G1 in Fig. 2, the variation amount of the terminal voltage per predetermined time time, that is, the slope of graph G1, is the largest immediately after the charging is stopped. Therefore, where step S6 is performed immediately after the charging is stopped by the charging stopping unit 242, the values of the voltage decrease rate dV1/dt, dV2/dt, ..., dVN/dt increase over that obtained when step S6 is performed after a certain time has elapsed since the charge stop. As a result, the accuracy of failure detection in the below-described step S8 is increased.

The failure detection unit 243 then substitutes "1" as a variable n (step S7). The, the failure detection unit 243 compares the absolute value of the voltage decrease rate dVn/dt with a reference value γ (step S8).

In this case, the terminal voltage of the electricity storage element 11 changes, for example as shown in Fig. 2, after the charging is stopped. Therefore, if no failure occurs in the voltage detection unit 201, the terminal voltage Vn detected by the voltage detection unit 201 can be predicted to demonstrate at least some variation. Accordingly, for example, a value such that can absorb the detection error of the voltage detection unit 201 is set as the reference value γ.

In such a case, where the absolute value of the voltage decrease rate dVn/dt is less than the reference value γ (YES in step S8), the terminal voltage Vn detected by the voltage detection unit 201 substantially does not change and the predicted variation is not obtained. Therefore, the failure detection unit 243 determines that a failure has occurred in the voltage detection unit 201 (step S9) and ends the processing, for example, after prohibiting the charging with the charge-discharge control circuit 30 (step S10) and reporting the failure.

For example, as shown in Fig. 2, the decrease amount per predetermined time of the terminal voltage of the electricity storage element 11 after the charging is stopped decreases with the decrease in SOC. Therefore, where the processing of step S5 and subsequent steps is performed when the SOC is extremely small, the absolute value of the voltage decrease rate dVn/dt becomes extremely small. As a result, a failure can be erroneously determined to have occurred in the voltage detection unit 201.

However, with the power supply device 2, where the processing of step S4 is executed, the SOC of the electricity storage unit B assumes an upper limit value of the range of SOC that has been set in advance as a target for using the electricity storage unit B, for example 100% or a comparatively high value of 80%. Therefore, a value higher than the reference value γ can be obtained with higher reliability as the absolute value of the voltage decrease rate dVn/dt when no failure has occurred in the voltage detection unit 201. As a result, the probability of erroneously determining that a failure has occurred in the voltage detection unit 201 is reduced.

Therefore, it is less probable that safety will decrease and the deterioration of the electricity storage unit B will advance because the terminal voltage V1, V2, ..., VN cannot be detected correctly due to the failure of the voltage detection unit 201.

Where the absolute value of the voltage decrease rate dVn/dt is equal to or higher than the reference value γ, (NO in step S8), the variation of the terminal voltage Vn following the termination of charging is detected by the voltage detection unit 201. Therefore, the failure detection unit 243 adds "1" to the variable n that should verify whether or not the terminal voltage of the other electricity storage unit has been determined correctly (step S11).

Then, the failure detection unit 243 compares the variable n with the number N of electricity storage units (step S12). Where the variable n is equal to or less than the number N of electricity storage units (NO in step S12), the steps S8 to S12 of inspecting the operation of detecting the terminal voltage for other electricity storage units are repeated.

Where the variable n exceeds the number N of electricity storage units (YES in step S12), it means that the operation of detecting the terminal voltage for all of the electricity storage units has ended, a transition is made to step S13, no failure is determined to have occurred in the voltage detection unit 201 (step S13), and the processing is ended.

In the above-described example, the reference range for detecting a failure in step S8 is equal to or higher than the reference value γ. However, instead of using the reference value γ, it is possible, for example, to determine and set, for example experimentally, the predicted upper limit value and lower limit value of the voltage decrease rate dVn/dt obtained immediately after the charging is stopped when the SOC of the electricity storage units element B is at the determination value α and determine that a failure has occurred in the voltage detection unit 201 when the voltage decrease rate dVn/dt is outside the reference range indicated by these upper limit value and lower limit value.

In this case, it is possible to determine a failure on the basis of whether the variation of the terminal voltage V1, V2, ... VN can be detected by the voltage detection unit 201 and also on the basis of the degree of the detected variation. Therefore, the failure detection accuracy is increased.

With the processing of the above-described steps S1 to S13, it is not necessary to attempt charging the electricity storage unit B to an abnormality determination level that exceeds the usual range of use, as in the method disclosed in the aforementioned Patent Document 1. Therefore, an abnormality of the voltage detection unit 201, which detects the terminal voltage of the electricity storage unit B, can be detected without accelerating the deterioration of the electricity storage unit B. As a result, the service life of the electricity storage unit B can be extended and safety can be easily increased.

A method for detecting the variation of the terminal voltage which is detected by the voltage detection unit 201 after the charging is stopped by the charging stopping unit 242, and a determination method therefor are not particularly limited and a variety of methods can be used therefor.

For example, the failure detection unit 243 may also determine that a failure has occurred in the voltage detection unit 201 when the time required for the variation amount of the terminal voltage per predetermined time that has been set in advance to become a set variation amount that has been set in advance, after the charging is stopped, is outside the preset reference range.

Further, the failure detection unit 243 may also determine that a failure has occurred in the voltage detection unit 201 when the variation amount of the terminal voltage, which is detected by the voltage detection unit 201, within an interval before a preset time that has been set in advance elapses after the charging is stopped, is outside the preset reference range.

Further, the failure detection unit 243 may also determine that a failure has occurred in the voltage detection unit 201 when the time before the variation amount of the terminal voltage detected by the voltage detection unit 201 after the charging is stopped reaches a preset variation amount that has been set in advance is outside the preset reference range.

Further, the failure detection unit 243 may also determine that a failure has occurred in the voltage detection unit 201 when the variation amount of the terminal voltage after the charging is stopped and before the terminal voltage, which is detected by the voltage detection unit 201, becomes a stationary state is outside the preset reference range.

Further, the failure detection unit 243 may also determine that a failure has occurred in the voltage detection unit 201 when the time interval after the charging is stopped and before the terminal voltage, which is detected by the voltage detection unit 201, becomes a stationary state is outside the preset reference range.

The power supply device 2 shown in Fig. 1 is not limited to the configuration described hereinabove and may have any configuration, provided that the power supply device has the same functions. For example, a program for realizing the above-described processing operations can be installed in the control unit 204 and the control can be realized by executing the program.

A mode in which the charge-discharge control circuit 30 functions as the control unit 204 can be also considered. In such a mode, a program for realizing the processing operations shown in Fig. 3 can be installed in the microcomputer constituting the charge-discharge control circuit 30 and the control by the control unit 204 can be realized by executing the program.

Further, a mode in which the control unit 204 functions as the failure detection unit 243 is not limiting. For example, a configuration may be used in which the charge-discharge control circuit 30 or load device 200 obtains information on the electricity storage element from the control unit 204 and functions as the failure detection unit 243 or other configurations may be used. The embodiments of the invention disclosed herein are merely exemplary and the present invention is not limited thereto.

The failure diagnosis circuit according to one aspect of the present invention includes: a voltage detection unit that detects a terminal voltage of an electricity storage unit; a current detection unit that detects a current flowing in the electricity storage unit; a SOC calculation unit that calculates a SOC of the electricity storage unit on the basis of the current detected by the current detection unit; a charging stopping unit that stops charging of the electricity storage unit when the SOC calculated by the SOC calculation unit reaches a preset determination value; and a failure detection unit that determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.

The failure diagnosis method according to another aspect of the present invention includes: a step in which a voltage detection unit detects a terminal voltage of an electricity storage unit; a step in which a current detection unit detects a current flowing in the electricity storage unit; a step in which a SOC calculation unit calculates a SOC of the electricity storage unit on the basis of the current detected by the current detection unit; a step in which a charging stopping unit stops charging of the electricity storage unit when the SOC calculated by the SOC calculation unit reaches a preset determination value; and a step in which a failure detection unit determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.

The variation of the terminal voltage after the charging of the electricity storage unit is stopped is determined according to the SOC. Accordingly, with such a configuration, charging of the electricity storage unit is stopped when the SOC calculated on the basis of current flowing in the electricity storage unit becomes the determination value. Where the variation of the terminal voltage, which is detected by the voltage detection unit, after the charging is stopped by the charging stopping unit differs from the predicted variation when the SOC of the electricity storage unit is at the determination value, it is highly probable that the terminal voltage detected by the voltage detection unit is erroneous. Therefore, when the variation of the terminal voltage, which is detected by the voltage detection unit, after the charging is stopped by the charging stopping unit differs from the predicted variation when the SOC of the electricity storage unit is at the determination value, a failure can be determined to have occurred in the voltage detection unit. In this case, it is not necessary to charge the electricity storage unit to a level above the usual range of use in order to perform failure diagnosis of the voltage detection circuit which detects the terminal voltage of the electricity storage unit. Therefore the failure of the voltage detection unit can be detected without accelerating the deterioration of the electricity storage unit.

Further, it is preferred that the determination value be an upper limit value of a range of SOC that has been set in advance as a target for using the electricity storage unit.

Where the upper limit value of the range of SOC that has been set in advance as a target for using the electricity storage unit is set as the determination value, the charging can be stopped when it is necessary to stop the charging to control the SOC in a target range irrespectively of the failure diagnosis operation performed by the failure diagnosis circuit and failure diagnosis can be executed. Therefore, since the necessity of stopping the charging of the electricity storage unit for failure diagnosis is eliminated, the convenience of the failure diagnosis circuit in use can be increased.

Further, it is preferred that the determination value be a value of SOC indicating that the electricity storage unit is fully charged.

When the electricity storage unit is fully charged, the charging is generally stopped to avoid overcharging. Therefore, where the value of SOC indicating that the electricity storage unit is fully charged is set as the determination value, it is possible to stop the charging when it is necessary to stop the charging in order to avoid the overcharging of the electricity storage unit irrespectively of the failure diagnosis operation performed by the failure diagnosis circuit and then execute the failure diagnosis. Therefore, it is not necessary to stop the charging of the electricity storage unit only to perform failure diagnosis. As a result, the convenience of the failure diagnosis circuit in use can be increased.

It is further preferred that the failure detection unit determine that a failure has occurred in the voltage detection unit when a variation amount per predetermined time of the terminal voltage, which is detected by the voltage detection unit, after the charging is stopped is outside a preset reference range.

In this case, a spread of variation of the terminal voltage, which is detected by the voltage detection unit, after the charging is stopped, this spread being caused by the effect, for example, of a spread of properties among the electricity storage units, is less than that of the terminal voltage of the electricity storage unit when the SOC is at the predetermined value. Therefore, where a failure is determined to have occurred in the voltage detection unit when a variation amount per predetermined time of the terminal voltage, which is detected by the voltage detection unit, after the charging is stopped is outside a preset reference range, the accuracy of failure diagnosis is increased over that attained when failure diagnosis is conducted by simply comparing the terminal voltage of the electricity storage unit obtained with the voltage detection unit when the SOC is at the determination value with a preset reference value.

It is also preferred that in the electricity storage unit a decrease amount per predetermined time of the terminal voltage after the charging is stopped increases with the increase in SOC.

With such a configuration, since the determination value is set to a large value and the charging is stopped when the SOC is large, the predicted decrease amount of the terminal voltage per predetermined time increases. Accordingly, the predicted variation that serves as a reference for comparison with the variation of terminal voltage, which is detected by the voltage detection unit, after the charging is stopped by the charging stopping unit increases. As a result, the accuracy of failure determination by the failure detection unit increases.

The electricity storage unit is preferably a lithium ion secondary battery using an olivine-type lithium transition metal phosphate as a positive electrode active material.

In a lithium ion secondary battery using an olivine-type lithium transition metal phosphate as a positive electrode active material, the decrease amount of terminal voltage occurring when the charging is stopped increases with the increase in SOC. Therefore, such a battery is advantageous as the abovementioned electricity storage unit.

The positive electrode active material is preferably LiₓA_{y}B_{z}PO₄ (where A is at least one species selected from Me, Fe, Mn, Co, Ni, and Cu; B is at least one species selected from Mg, Ca, Sr, Sc, Y, Ti, Zr, V, Nb, Cr, Mo, W, Ag, Zn, In, Sn, and Sb; and 0 < X ≤ 1, 0.9 ≤ Y ≤ 1, 0 ≤ Z ≤ 0.1).

A lithium ion secondary battery using, as the positive electrode active material, LiₓA_{y}B_{z}PO₄ (where A is at least one species selected from Me, Fe, Mn, Co, Ni, and Cu; B is at least one species selected from Mg, Ca, Sr, Sc, Y, Ti, Zr, V, Nb, Cr, Mo, W, Ag, Zn, In, Sn, and Sb; and 0 < X ≤ 1, 0.9 ≤ Y ≤ 1, 0 ≤ Z ≤ 0.1) is advantageous as the abovementioned electricity storage unit, because the decrease amount of terminal voltage occurring when the charging is stopped increases with the increase in SOC.

It is preferred that a charging unit that supplies a charge current to charge the electricity storage unit be further provided and the charging stopping unit stop the charging of the electricity storage unit by the charging unit when the SOC calculated by the SOC calculation unit becomes equal to or higher than the preset determination value during charging with the charging unit.

With such a configuration, the charging state of the electricity storage unit is obtained with the charging unit. The charging stopping unit stops the charging with the charging unit when the SOC calculated by the SOC calculation unit becomes equal to or higher than the preset determination value, thereby making it possible to change the state of the electricity storage unit from the charging state to the charging stop state and execute failure diagnosis with the failure detection unit.

It is further preferred that the charging stopping unit stop the charging of the electricity storage unit when the SOC calculated by the SOC calculation unit becomes equal to or higher than the preset determination value when the current detected by the current detection unit is a current flowing in a direction of charging the electricity storage unit.

With such a configuration, the charging stopping unit can detect that the electricity storage unit is being charged, irrespectively of failure detection, on the basis of electric current detected by the current detection unit, and failure determination by the failure determination unit can be executed by stopping the charging of the electricity storage unit when the SOC calculated by the SOC calculation unit is equal to or higher than the preset determination value. Therefore, it is not necessary to charge the electricity storage unit for only failure determination.

It is preferred that the electricity storage unit be provided in plurality, the voltage detection unit detect the terminal voltage of each of the electricity storage units, and the failure detection unit determine that a failure has occurred in the voltage detection unit when a variation of each terminal voltage, which is detected by the voltage detection unit, after the charging is stopped by the charging stopping unit differs from a predicted variation when the SOC of each of the electricity storage units is at the determination value.

With such a configuration, a failure of the voltage detection unit can be detected even in the case of a configuration in which a plurality of electricity storage units are provided and the voltage detection unit detects the terminal voltage of each electricity storage unit.

The power supply device according to another aspect of the present invention includes the above-described failure diagnosis circuit and the electricity storage unit.

With such a configuration it is not necessary to charge the electricity storage unit to a level exceeding the usual range of use in order to perform failure diagnosis of the voltage detection unit that detects terminal voltage of the electricity storage unit in a power supply device including the electricity storage unit. Therefore, a failure of the voltage detection unit can be detected, without accelerating the deterioration of the electricity storage unit.

### Industrial Applicability

The failure diagnosis circuit in accordance with the present invention, the power supply device using same, and the failure diagnosis method can be advantageously used in electronic devices such as portable personal computers, digital cameras, and cellular phones, vehicles such as electric automobiles and hybrid cars, and battery-carrying devices and systems such as power supply systems in which a solar cell or a power generating device is combined with a secondary battery.

## Claims

1. A failure diagnosis circuit comprising:
a voltage detection unit that detects a terminal voltage of an electricity storage unit;
a current detection unit that detects a current flowing in the electricity storage unit;
a SOC calculation unit that calculates a SOC of the electricity storage unit on the basis of the current detected by the current detection unit;
a charging stopping unit that stops charging of the electricity storage unit when the SOC calculated by the SOC calculation unit reaches a preset determination value; and
a failure detection unit that determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.

2. The failure diagnosis circuit according to claim 1,
wherein the determination value is an upper limit value of a range of SOC that has been set in advance as a target for using the electricity storage unit.

3. The failure diagnosis circuit according to claim 2,
wherein the determination value is a value of SOC indicating that the electricity storage unit is fully charged.

4. The failure diagnosis circuit according to any one of claims 1 to 3,
wherein the failure detection unit determines that a failure has occurred in the voltage detection unit when a variation amount per predetermined time of the terminal voltage, which is detected by the voltage detection unit, after the charging is stopped is outside a preset reference range.

5. The failure diagnosis circuit according to any one of claims 1 to 4,
wherein, in the electricity storage unit, a decrease amount per predetermined time of the terminal voltage after the charging is stopped increases with the increase in SOC.

6. The failure diagnosis circuit according to claim 5,
wherein the electricity storage unit is a lithium ion secondary battery using an olivine-type lithium transition metal phosphate as a positive electrode active material.

7. The failure diagnosis circuit according to claim 6,
wherein the positive electrode active material is LiₓA_{y}B_{z}PO₄
(where A is at least one species selected from Me, Fe, Mn, Co, Ni, and Cu; B is at least one species selected from Mg, Ca, Sr, Sc, Y, Ti, Zr, V, Nb, Cr, Mo, W, Ag, Zn, In, Sn, and Sb; and 0 < X ≤ 1, 0.9 ≤ Y ≤ 1,0 ≤ Z ≤ 0.1).

8. The failure diagnosis circuit according to any one of claims 1 to 7, further comprising:
a charging unit that supplies a charge current to charge the electricity storage unit,
wherein the charging stopping unit stops the charging of the electricity storage unit by the charging unit when the SOC calculated by the SOC calculation unit becomes equal to or higher than the preset determination value during charging with the charging unit.

9. The failure diagnosis circuit according to any one of claims 1 to 7,
wherein the charging stopping unit stops the charging of the electricity storage unit when the SOC calculated by the SOC calculation unit becomes equal to or higher than the preset determination value when the current detected by the current detection unit is a current flowing in a direction of charging the electricity storage unit.

10. The failure diagnosis circuit according to any one of claims 1 to 9,
wherein the electricity storage unit is provided in plurality,
the voltage detection unit detects the terminal voltage of each of the electricity storage units, and
the failure detection unit determines that a failure has occurred in the voltage detection unit when a variation of each terminal voltage, which is detected by the voltage detection unit, after the charging is stopped by the charging stopping unit differs from a predicted variation when the SOC of each of the electricity storage units is at the determination value.

11. A power supply device comprising:
the failure diagnosis circuit according to any one of claims 1 to 10; and
the electricity storage unit.

12. A failure diagnosis method comprising:
a step in which a voltage detection unit detects a terminal voltage of an electricity storage unit;
a step in which a current detection unit detects a current flowing in the electricity storage unit;
a step in which a SOC calculation unit calculates a SOC of the electricity storage unit on the basis of the current detected by the current detection unit;
a step in which a charging stopping unit stops charging of the electricity storage unit when the SOC calculated by the SOC calculation unit reaches a preset determination value; and
a step in which a failure detection unit determines that a failure has occurred in the voltage detection unit when a variation of the terminal voltage, which is detected by the voltage detection unit, after the charging is stopped by the charging stopping unit differs from a predicted variation when the SOC of the electricity storage unit is at the determination value.
